# EUROPEAN PATENT APPLICATION

(11) **EP 2 660 845 A1**
(43) Date of publication of application: **06.11.2013**
(21) Application number: 12166368.6
(22) Date of filing: 02.05.2012
(51) Int. Cl.: H01J 37/22, H01J 37/28

(54) **Charged-particle microscopy with image stitching**

(71) Applicant: FEI Company, Hillsboro, OR 97124-5793 (US)
(72) Inventor: Janus, Michael, 5251 BK Vlijmen (NL); Gestmann, Ingo, 47198 Duisburg (DE)
(74) Representative: Bakker, Hendrik

(57) **Abstract**

A method of producing a composite image of a sample using a charged-particle microscope, the composite image comprising a plurality of sub-images that are stitched together along overlap zones, said method comprising the following steps:
- Mounting the sample on a sample holder;
- Using a particle-optical column to direct at least one input beam of particulate radiation onto the sample, thereby producing an interaction that causes a plurality of different types of output radiation to emanate from the sample;
- Detecting a first type of output radiation and using it to produce:
■ A sub-image I_{1A} of a primary region R_{A} of the sample;
■ A sub-image I_{1B} of a secondary region R_{B} of the sample,
whereby R_{B} is adjacent to R_{A} and overlaps partially therewith, and I_{1B} has an overlap zone Z₁ with I_{1A},
which method comprises the following steps:

- Detecting a second type of output radiation, different to said first type, and using it to produce:
■ A sub-image I_{2A} of primary region R_{A};
■ A sub-image I_{2B} of secondary region R_{B},
whereby I_{2B} has an overlap zone Z₂ with I_{2A};

- Using computer processing apparatus to:
■ Elect one of the sub-image pairs (I_{1A}, I_{1B}) and (I_{2A}, I_{2B});
■ For the sub-image pair thus elected, calculate the relative shift Δ of its two sub-images that is required to bring them into mutual registration, and stitch the two sub-images together after effecting this shift Δ;
■ For the other of the sub-image pairs, stitch its two sub-images together on the basis of the same relative shift Δ.

In an aspect of this method, said computer processing apparatus is used to:
- Examine correlation of I_{1B} to I_{1A} within zone Z₁;
- Examine correlation of I_{2B} to I_{2A} within zone Z₂;
- Use the outcome of these examinations in performing said election.

## Description

The invention relates to a method of producing a composite image of a sample using a charged-particle microscope, the composite image comprising a plurality of sub-images that are stitched together along overlap zones, said method comprising the following steps:
- Mounting the sample on a sample holder;
- Using a particle-optical column to direct at least one input beam of particulate radiation onto the sample, thereby producing an interaction that causes a plurality of different types of output radiation to emanate from the sample;
- Detecting a first type of output radiation and using it to produce:
   ■ A sub-image I_{1A} of a primary region R_{A} of the sample;
   ■ A sub-image I_{1B} of a secondary region R_{B} of the sample,
   whereby R_{B} is adjacent to R_{A} and overlaps partially therewith, and I_{1B} has an overlap zone Z₁ with I_{1A}.

The invention also relates to a charged-particle microscope in which such a method is performed.

As used throughout this text, the ensuing terms should be interpreted as follows:
- The term "charged particle" refers to an electron or ion (generally a positive ion, such as a Gallium ion or Helium ion, for example).
- The term "microscope" refers to an apparatus that is used to create a magnified image of an object, feature or component that is generally too small to be seen in satisfactory detail with the naked human eye. In addition to having an imaging functionality, such an apparatus may also have a machining functionality; for example, it may be used to locally modify a sample by removing material therefrom ("milling" or "ablation") or adding material thereto ("deposition"). Said imaging functionality and machining functionality may be provided by the same type of charged particle, or may be provided by different types of charged particle; for example, a Focused Ion Beam (FIB) microscope may employ a (focused) ion beam for machining purposes and an electron beam for imaging purposes (a so-called "dual beam" microscope, or "FIB-SEM"), or it may perform machining with a relatively high-energy ion beam and perform imaging with a relatively low-energy ion beam. On the basis of this interpretation, tools such as the following should be regarded as falling within the scope of the current invention: electron microscopes, FIB apparatus, EBID and IBID apparatus (EBID = Electron-Beam-Induced Deposition; IBID = lon-Beam-Induced Deposition), *etc.*

- The term "particle-optical column" refers to a collection of electrostatic and/or magnetic lenses that can be used to manipulate a charged-particle beam, serving to provide it with a certain focus or deflection, for example, and/or to mitigate one or more aberrations therein.
- The term "output radiation" encompasses any radiation that emanates from the sample as a result of its irradiation by the imaging beam. Such output radiation may be particulate and/or photonic in nature. Examples include secondary electrons, backscattered electrons, X-rays, visible fluorescence light, and combinations of these. The output radiation may simply be a portion of the imaging beam that is transmitted through or reflected from the sample, or it may be produced by effects such as scattering or ionization, for example.
- The term "type" as used with regard to output radiation / sample imagery should be broadly interpreted. It may, for example, refer to characteristics such as the following:
   ■ The *nature* of output radiation, e.g. whether it is electromagnetic or (charged) particulate.
   ■ The *wavelength* of output radiation, e.g. whether it is X-ray, ultra-violet, visible light, infra-red, *etc.*
   ■ The *energy* of output radiation, e.g. whether an emitted electron can be classified as low-energy (as with a secondary electron) or high-energy (as with a backscattered electron).

In what follows, the invention will - by way of example - often be set forth in the specific context of electron microscopes. However, such simplification is intended solely for clarity/illustrative purposes, and should not be interpreted as limiting.

Electron microscopy is a well-known technique for imaging microscopic objects. The basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" beam of ions, allowing supportive activities such as ion-beam milling or ion-beam-induced deposition, for example. In traditional electron microscopes, the imaging beam is "on" for an extended period of time during a given imaging session; however, electron microscopes are also available in which imaging occurs on the basis of a relatively short "flash" or "burst" of electrons, such an approach being of potential benefit when attempting to image moving samples or radiation-sensitive specimens, for example.

When an input beam of particulate radiation (such as an electron beam or ion beam) impinges on a sample, it generally interacts with the sample in a manner that causes different types of output radiation to emanate from the sample. Such emitted radiation may, for example, comprise Secondary Electrons (SEs), Backscatter Electrons (BEs), optical radiation (i.e. visible, infrared and/or ultraviolet light - e.g. in the form of fluorescence or cathodoluminescence), secondary ions and X-rays. Such different types of output radiation are generally detected using different detectors and/or the same detector used in different modes, configurations or settings. For example:
- Electrons (SEs and/or BEs) can be detected using a scintillator in conjunction with a photomultiplier tube (PMT) or silicon photomultiplier (SiPM - also sometimes called a Multiple Pixel Photon Counter), or using a solid state detector such as a so-called "P-I-N diode" structure, for example.
- Optical radiation can be detected using a PMT or SiPM without a scintillator, or using a photodiode cell, for example.

The employed detector may be unitary, or it may be compound in nature and comprise a plurality of sub-detectors, e.g. as in the case of a spatial distribution of detector units about a sample holder, or a pixelated/segmented detector.

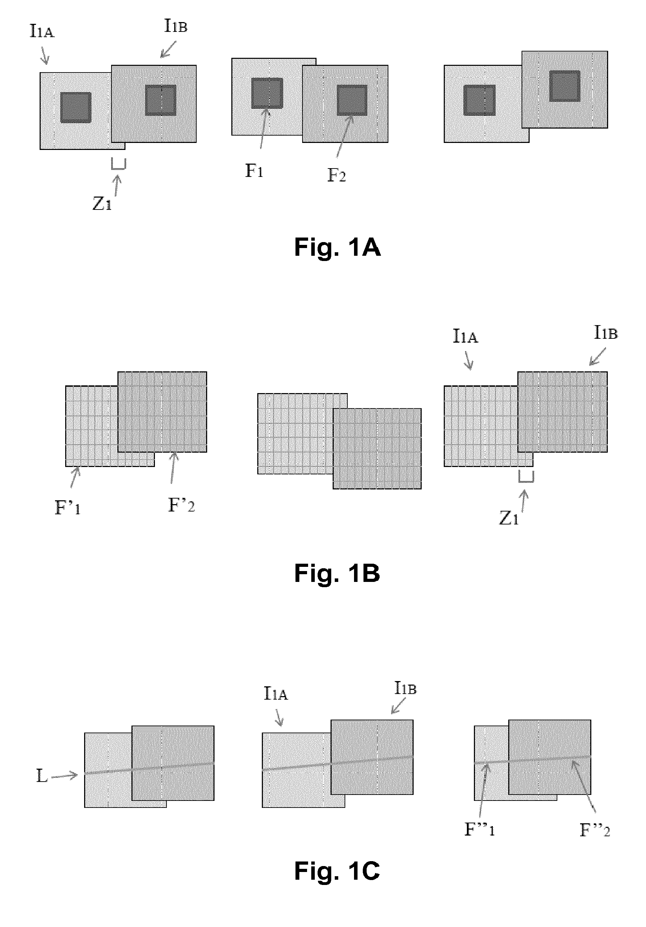

With increasing demand for larger images in charged-particle microscopy, there is increasing interest in "tiling and stitching" techniques, whereby a relatively large composite image is constructed from sub-images - so-called "tiles" - that are "stitched" together in overlap zones running along their peripheries. Since a stage used to position/drive the employed sample holder during capture of each sub-image and between capture of successive sub-images will have limited accuracy, the success of such techniques will depend on how well the captured tiles can be mutually "registered" (aligned) along adjacent overlap zones. Such registration can, in principle, be automatically performed by software that employs image recognition and correlation algorithms; however, for such software to work satisfactorily, the employed overlap zones will have to comprise enough distinct features to allow the underlying image recognition and correlation calculations to yield a sufficiently certain result. Compounding this problem is the fact that, whereas a microscope operator will generally want to acquire images that are visually "appealing" and/or that highlight specific structures or material properties relevant to a particular study, such images may not be sufficiently feature-rich and/or have satisfactory types of features for purposes of sub-image registration / stitching. For example, an overlap zone between two tiles may contain:
- Essentially no usable features for automatic registration purposes (see Fig 1A). In such an instance, image recognition / correlation algorithms will basically have no satisfactory features to work with.
- Features that are repetitive (see Fig 1B). In such a case, registration of adjacent tiles in a given direction will generally be uncertain by an amount nP, where P is the repetition period in said direction and n is a natural number.
- Features that extend from one tile to the other along a common straight line L (see Fig 1C), In such a case, the correct registration position along L will generally be unclear.
One can elucidate this issue by introducing the concept of a "match score" M, being a variable that expresses an observed (measured) degree of unambiguous/unique (mathematical) correlation (i.e. alignment / agreement) between two sub-images in an overlap zone. Such a variable M will have a low (or even zero) value in the three scenarios just explained above, on the basis of which employed registration software can signal (e.g. on a user interface) that it is unable to stitch the two sub-images involved with a satisfactory degree of confidence (which may be defined by comparing the value of M to a pre-defined threshold, for example). In such a case, the operator of the microscope will have to intervene and stitch the sub-images manually, or at least manually inspect/grade a number of stitching proposals made by said software. Such an interruption of automated measurement flow is generally undesirable.

The skilled artisan will be familiar with the concepts of tiling and stitching, and will realize that there various commercially available software tools that can automatically analyze correlation and perform registration of overlapping images. An example of such software is *AutoStitch* (which is freeware). For more information on this subject matter, one can refer to sources such as the following:
- http://en.wikipedia.org/wiki/lmage_stitching
- http://www.caam.rice.edu/∼zhang/caam699/p-files/Im-Align2005.pdf
- Bin Ma, Timo Zimmermann, Manfred Rohde, Simon Winkelbach, Feng He, Werner Lindenmaier, Kurt E.J. Dittmar, Use of AutoStitch for automatic stitching of microscope images, Micron, Volume 38, Issue 5, July 2007, Pages 492-499.

It is an object of the invention to address the issues raised above. More specifically, it is an object of the invention to provide an imaging method that is better able to perform registration/stitching of microscopy sub-images so as to produce a composite image. In particular, it is an object of the invention that such improved registration/stitching ability should not come at the expense of general imaging quality of substantive features outside the overlap zones of the stitched images.

These and other objects are achieved in a method as specified in the opening paragraph, characterized by the following steps:
- Detecting a second type of output radiation, different to said first type, and using it to produce:
   ■ A sub-image I_{2A} of primary region R_{A};
   ■ A sub-image I_{2B} of secondary region R_{B},
      whereby I_{2B} has an overlap zone Z₂ with I_{2A};
- Using computer processing apparatus to:
   ■ Elect one of the sub-image pairs (I_{1A}, I_{1B}) and (I_{2A}, I_{2B});
   ■ For the sub-image pair thus elected, calculate the relative shift Δ of its two sub-images that is required to bring them into mutual registration, and stitch the two sub-images together after effecting this shift Δ;
   ■ For the other of the sub-image pairs, stitch its two sub-images together on the basis of the same relative shift Δ.

In research leading to the invention, the inventors realized that different types of output radiation from a given sample distinguish themselves *inter alia* via the sort/extent of sample features that they (best) reveal. Accordingly, an overlap zone between two sub-images might be relatively devoid of suitable registration features for a first type of output radiation (bad/lower M-value), but much richer in such features for a second (different) type of output radiation (good/higher M-value). However, such a second type of output radiation will often produce unsatisfactory imaging results as regards the main, substantive sample features being studied in a particular measurement session (e.g. a particular type of biological cell, or a particular type of grain in a mineralogical sample, or a particular electrical structure in an integrated circuit, for instance). The inventors realized that this impasse could be addressed by using *both* types of output radiation: examination of substantive features in sub-images could occur using the type of output radiation best suited thereto, but the actual registration/stitching of such sub-images could occur on the basis of another type of output radiation more suited to the task of (automated) correlation/registration in the overlap zones in question (e.g. yielding a better M-value). More specifically, one could apply the following approach:
- For the latter type of output radiation (e.g. with the better M-value), determine the relative shift Δ of two sub-images required to register/stitch them satisfactorily;
- For the former type of output radiation (being used for substantive feature examination), "blindly" use said shift Δ in order to register/stitch the corresponding two sub-images.

In this context, it should be noted that the shift Δ may comprise a sum/resultant of one or more types of mathematical mapping/transform, such as:
- A linear translation;
- An angular rotation;
- A projective change (i.e. magnification difference);
- A skew adjustment,
   *etc.*

In its most general form it should therefore be regarded as a vectorial or tensor quantity.

With regard to the extent to which different types of features can be imaged by different types of output radiation, reference can be made to examples such as the following:
- One type of output radiation may be more suited to imaging bulk/volume features, whereas another type of output radiation may be more tailored to revealing topographical/surface features. For example, such a distinction applies, respectively, to backscatter electrons and secondary electrons. The topographical features involved may be "deliberate" (e.g. grooves or scores of some sort), or "accidental" (e.g. scratches, dust particles, *etc.*).
- A biological sample might contain different types of cell, which are imaged differently by different types of output radiation.
- Similarly, a mineralogical sample might contain different chemical compounds and/or grain/crystal structures, with different visibility for different types of output radiation.
The skilled artisan will grasp such differences, and will be able to think of various other examples in this regard.

One can conceive various criteria that can be used by the computer processing apparatus to perform said election of the sub-image pair (I_{1A}, I_{1B}) or (I_{2A}, I_{2B}) to be used to determine Δ. For example, previous experience may have revealed a type of output radiation that (typically) best lends itself (or, at least, better lends itself) to usable imaging of correlation/registration features in the overlap zone between sub-images; in such a scenario, the computer processing apparatus could simply refer to a (type of) look-up table so as to arrive at an election result. In an alternative (and more general) scenario, said computer processing apparatus is used to:
- Examine correlation of I_{1B} to I_{1A} within zone Z₁;
- Examine correlation of I_{2B} to I_{2A} within zone Z₂;
- Use the outcome of these examinations in performing said election.

Such an approach is more adaptable/flexible than the mere (passive) consultation of a look-up table, for example, in that it provides a mechanism on the basis of which the computer processing apparatus can (actively) objectively perform the required election on a case-by-case basis, using a criterion (degree of correlation / ease of registration) that is central to the task of automatic stitching. It should be noted in this context that said examination procedure need not necessarily reveal an obvious best-case "winner" among the examined correlations, and that the computer processing apparatus can, in such "convoluted" instances, resort to various algorithms to arrive at an election result. For example, one can conceive a scenario whereby both correlations are judged to be comparable/equivalent: one could then, for example, choose to randomly elect either sub-image pair for determination of Δ, or make an election based on other (pre-programed) criteria not related to image registration.

In a further refinement of the scenario discussed in the previous paragraph, the computer processing apparatus is used to:
- Produce a match score M₁ that expresses an observed degree of unambiguous correlation between I_{1B} and I_{1A};
- Produce a match score M₂ that expresses an observed degree of unambiguous correlation between I_{2B} and I_{2A};
- Determine a best one of the match scores M₁, M₂ and, on that basis, perform said election.

Such an approach provides a quantifiable criterion by which to judge the suitability of the sub-image pairs for determination of Δ. Once again, the concept of "a best one of the match scores M₁, M₂" encompasses the (unlikely) possibility that M₁ and M₂ are exactly equal, in which the election can occur as set forth at the end of the previous paragraph, for example. Another conceivable possibility is that:
- As regards sub-image pair (I_{1A}, I_{1B}), more than one unique correlation scenario is determined (e.g. as in the case of a (quasi-)repetitive structure), leading to more than one match score, e.g. M₁ and M₁'.
- As regards sub-image pair (I_{2A}, I_{2B}), a match score M₂ is determined, with M₂ < M₁ but M₂ ≈ M₁'_{.}

In this case, a "best" match score might be the one that produces most consistency (M₂ ≈ M₁') rather than the one with the highest value (M₁). This is a matter of choice, and such scenarios can be pre-programmed into the computer processing apparatus - either to be resolved in a self-contained manner or by invoking the intervention of the microscope user on a case-by-case basis, as the need arises. Scenarios such as these all fall within the scope of the present invention and claims, and it will be well within the capability of the skilled artisan to come up with similar such scenarios.

It should be noted that the use of the labels "first" and "second" with regard to the sub-image pairs does not dictate a temporal sequence. For example, in a given measurement session, one might accrue sub-images I_{1A} and I_{2A} at a sample region R_{A}, and thereafter accrue sub-images I_{1B} and I_{2B} at a sample region R_{B}. Such a scenario might, for example, be convenient in the case of imaging using EDS (Energy Dispersive Spectroscopy).

In a particular aspect of the current invention, the first and second types of output radiation are detected *simultaneously* (during the same measurement run). This has (*inter alia*) the advantage that the same spatial relationship will exist between the sub-images I_{1A}, I_{1B} as between the sub-images I_{2A}, I_{2B}, so that the above-mentioned "blind" application of the shift Δ can occur in a straightforward (direct) manner. In an alternative scenario, the first and second types of radiation are detected non-simultaneously (during sequential measurement runs). This complicates the situation somewhat in that the spatial relationship between the sub-images I_{1A}, I_{1B} may no longer be the same as that between the sub-images I_{2A}, I_{2B}, due to reproducibility issues such as drift/hysteresis in stage positioning, drift in detector settings, thermal effects in the sample, *etc.* In such a scenario, if a shift Δ is determined between one of said pairs of sub-images, the "blind" shift applied to the other of said pairs of sub-images will have the form Δ + δ, where δ is a (vectorial/tensor) correction factor that may be determined, for example, from a calibration run, calculation/modeling, previous experience, *etc.*

The latter scenario discussed in the previous paragraph (non-simultaneous detection) can, for example, occur in a so-called Energy-Filtered TEM (FTEM), in which radiation passing through - and scattered by - a sample is detected in an energy-filtered (energy-resolved) manner. For example, in such a scenario:
- The first type of output radiation (scattered electrons) has energy E₁, and is detected in measurement session S₁ using energy filter C₁ in combination with a detector D.
- The second type of output radiation (again, scattered electrons) has energy E₂, and is detected in measurement session S₂ using energy filter C₂ in combination with the same detector D.

The exploitation of energy resolution via use of the different filters C₁, C₂ will allow creation of a series of "spectrally differentiated" images, each of which can reveal different sample features to a greater or lesser extent. However, a possible issue with such a scenario is that, between measurement sessions S₁ and S₂, some aspect of the sample, sample holder (stage) and/or detector D may change, due to drift effects (e.g. thermal, hysteretic and/or radiation-induced drift/change). Such drift gives rise to the corrective term δ alluded to in the previous paragraph.

For good order, it should be noted that a further advantage of simultaneous detection is that it will generally cause less radiation damage to the sample in question, since all detector data can be acquired in a single measurement run. This will be of particular advantage in the case of delicate samples, such as are often encountered in biological investigations, for example. Another advantage of simultaneous detection is that it will (by its very nature) take less time.

In a particular embodiment of the current invention, the charged-particle microscope images the sample by performing relative scanning motion of the sample with respect to the input beam. Such is the case in tools such as a SEM, STEM or FIB, for example. Such a microscope lends itself particularly to the current invention because, at any point in time during the course of a scan, all output radiation is being emitted from an essentially point-like region of the sample; consequently, there will be a guaranteed correspondence between image sets accrued simultaneously using different types of output radiation.

In a particular aspect of the present invention, the decision as to whether a given M-value (or other correlation-judging criterion) is considered "best" - and the ensuing stitching operation - is conducted in a fully automatic value; in such a scenario, the employed computer processing apparatus operates in a wholly self-sufficient manner. However, one can also conceive scenarios in which it might be desirable to deviate from such a fully automatic approach. For example, in "borderline cases" - e.g. in which no M-value emerges as a clear winner, or in which even a winning M-value lies below a particular confidence threshold, or in which M is not purely quantitative in nature but also has qualitative aspects, *etc.* - the computer processing apparatus may indicate to the tool operator that he may intervene in the decision as to which type of output radiation gives the best correlation. This may, for example, involve the use of audio and/or visual prompts to draw the attention of the operator to the fact that the computer processing apparatus desires his input. Examples of such scenarios have already been alluded to above.

It is, of course, possible to extend/extrapolate the reasoning presented heretofore to more than two different types of output radiation. In a general scenario, N (≥ 2) different types of output radiation are detected, and the output radiation yielding the best (or one of the better) M-values can be chosen as a basis for the registration/stitching operation. In a situation in which multiple M-values are above an acceptance threshold, one could, if desired, elect to adopt an approach such as the following:
- Suppose, in a specific example, that N = 4, and that M₁ and M₃ are above a particular acceptance threshold, whereby M₁ and M₃ correspond, respectively, to a first and a third type of output radiation.
- Automatic analysis of the imagery captured using these first and third types of output radiation yields respective shift values Δ₁ and Δ₃ (required to effect proper registration of an overlapping image pair acquired using the respective output radiation types).
- Instead of using just Δ₁ or Δ₃ *severally* as a basis to effect stitching (for all types of output radiation), one could instead elect to use Δ₁ or Δ₃ *jointly,* e.g. by introducing a compound shift value such as:
   ■ A simple average value, e.g. Δ = ½ (Δ₁ + Δ₃).
   ■ A weighted average value, e.g. Δ = (M₁Δ₁ + M₃Δ₃) / (M₁ + M₃).
Scenarios such as these all fall within the scope of the present invention and claims, and it will be well within the capability of the skilled artisan to come up with similar such scenarios.

For the sake of completeness, it should be noted that use of the terms "primary" and "secondary" in this document with regard to regions R_{A} and R_{B} of a sample is not in any way intended to assign relative importance levels or magnitudes (for example) to said regions; the terms are merely used in a labeling fashion, to distinguish one region from the other. The logical extension of such labeling to further such regions would refer to "tertiary", "quaternary", *etc.*

The invention will now be elucidated in more detail on the basis of exemplary embodiments and the accompanying schematic drawings, in which:
Figure 1 renders plan views of various possible image registration scenarios pertaining to three different situations, each involving the existence of different categories of features in overlap zones between the registered sub-images.
Figure 2 renders a longitudinal cross-sectional view of aspects of a particle-optical microscope (in this case a SEM) with which the method according to the current invention can be implemented.

In the Figures, corresponding parts are indicated using corresponding reference symbols.

### Embodiment 1

Figures 1A, 1B and 1C render plan views of various possible image registration scenarios pertaining to three different situations, each involving the existence of different categories of features in overlap zones between the registered sub-images.

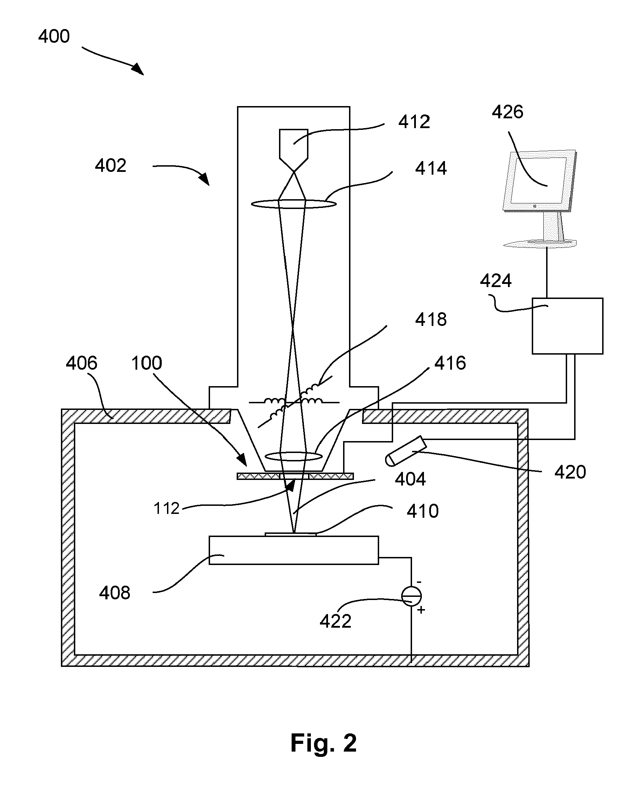

Figure 1A shows two sub-images (tiles) I_{1A}, I_{1B}, which partially overlap in an overlap zone Z₁. Both of these sub-images I_{1A}, I_{1B} were made in a charged-particle microscope [see Figure 2] on the basis of a first type of output radiation (e.g. backscatter electrons) [see discussion above, and Embodiment 2 below]. The two images I_{1A}, I_{1B} were respectively taken from adjacent and partially overlapping primary and secondary regions R_{A}, R_{B} of a sample (not shown). The sub-images I_{1A}, I_{1B} contain respective substantive features F₁, F₂, which are the targeted subject of a particular study, e.g. the features may comprise a particular type of neoplasm cell in a biological sample, or a particular type of mineral grain in a geological sample, for instance.

The substantive features F₁, F₂ are imaged very clearly using said first type of output radiation. However, for this first type of output radiation, the overlap zone Z₁ appears to be devoid of any features at all. As a result, image recognition / correlation software will basically have no features to work with in Z₁. Consequently, it will be impossible to decide on a unique, best-case registration of the images I_{1A}, I_{1B} - a fact that is illustrated by the three different registration scenarios depicted at left, center and right of Figure 1A.

The situation in Figure 1B is similar to that depicted in Figure 1A, except that the substantive features F'₁, F'₂ in Figure 1B are grid-like, e.g. as is often the case with semiconductor circuit samples. As here depicted, the periodic grid unit in F'₁, F'₂ repeats itself with a period P_{X} in the horizontal (x) direction and a period P_{Y} in the vertical (*y*) direction (not labeled in the Figure). As a result, in the overlap zone Z₁ between the images, if mutual registration occurs for a given relative (vectorial) position ***Q*** of I_{1A} and I_{1B}, then it will also occur for ***Q*** + (*n*P_{X}) ***x*** and/or ***Q*** + (*m*P_{Y}) ***y,*** where *n, m* are integers and ***x, y*** are unit vectors along *x, y.* Consequently, it will once again be impossible to decide on a unique, best-case registration of the images I_{1A}, I_{1B} - a fact that is illustrated once again by the three different registration scenarios depicted at left, center and right of Figure 1B.

The situation in Figure 1C is similar to that depicted in Figures 1A and 1B, except that the substantive features F"₁, F"₂ in Figure 1B are linear, e.g. as might be the case with a crystalline sample. If the linear substantive features F"₁, F"₂ are relatively positioned so as to be co-linear extensions of one another, then a common, straight line L will be formed. If I_{1A} or I_{1B} is moved in such a way as to "slide" along L, then this common, straight line L will be maintained. As a result, the correct registration position along L will be unclear. Consequently, it will once again be impossible to decide on a unique, best-case registration of the images I_{1A}, I_{1B} - a fact that is illustrated once again by the three different registration scenarios depicted at left, center and right of Figure 1C.

The invention addresses this problem by forming corresponding images I_{2A}, I_{2B} (not depicted) of (substantially) the same sample regions R_{A} and R_{B} using (at least one) *second* type of output radiation (different to the first type; e.g. optical fluorescence radiation). This second type of output radiation is chosen for its ability to reveal usable registration features in the overlap zone Z₂ between these images I_{2A}, I_{2B}; whether or not the *substantive* features F₁, F₂ are clearly imaged using this second type of output radiation is irrelevant in the current context, because F₁ and F₂ are satisfactorily imaged using the *first* type of output radiation. On the basis of the usable registration features in Z₂, computer processing apparatus [not depicted: see Figure 2] can calculate the relative shift Δ necessary to stitch I_{2A} to I_{2B}. The other images I_{1A} and I_{1B} can then be "blindly" stitched together on the basis of this same calculated shift Δ.

### Embodiment 2

Figure 2 shows a charged-particle microscope 400, which, in this case, is a SEM. The microscope 400 comprises a particle-optical column 402, which produces a charged-particle beam 404 (in this case, an electron beam). The particle-optical column 402 is mounted on a vacuum chamber 406, which comprising a sample holder / stage 408 for holding a sample 410. The vacuum chamber 406 is evacuated using vacuum pumps (not depicted). The sample holder 408, or at least the sample 410, may be biased (floated) to an electrical potential with respect to ground, with the aid of voltage source 422.

The particle-optical column 402 comprises an electron source 412, lenses 414, 416 to focus the electron beam 404 onto the sample 410, and a deflection unit 418. The apparatus is further equipped with a first detector 420, for detecting a first type of output radiation emanating from the sample 410 in response to irradiation by the input beam 404; in the present instance, the detector 420 is, for example, constructed so as to detect optical radiation or X-rays. Also depicted is a second detector 100, for detecting a second type of output radiation emanating from the sample 410 in response to irradiation by the input beam 404; in the present instance, the detector 100 is, for example, a segmented solid-state electron detector for detecting secondary electrons and/or backscatter electrons (and having a central aperture 112 to allow passage of the input beam 404). The apparatus further comprises a computer processing apparatus (controller) 424 for controlling *inter alia* the deflection unit 418, lenses 414, and detectors 420,100, and displaying information gathered from the detectors 420,100 on a display unit 426.

By scanning the beam input 404 over the sample 410, output radiation - comprising, for example, X-rays, secondary electrons, backscattered electrons, optical radiation and secondary ions - emanates from the sample 410. Since the output radiation is position-sensitive (due to said scanning motion), the information obtained from the detectors 420, 100, will also be position-dependent.

The signals from the detectors 420,100 are processed by the computer processing apparatus 424, and displayed on display unit 426. Such processing may include combining, integrating, subtracting, false colouring, edge enhancing, and other processing known to the person skilled in the art. In addition, automated recognition processes, e.g. as used for particle analysis, may be included in such processing. In the context of the current invention, the processing apparatus 424 (or a different computer processing apparatus) may additionally perform tasks such as:
- Storing/running one or more software modules for the purpose of performing tasks such as image recognition, correlation searching and image registration, for imagery accrued using various different types of output radiation.
- Storing/running one or more software modules for the purpose of grading correlation results, producing match scores, deciding/voting on workable registration scenarios, ranking registration results, and calculating relative shifts (Δ) required to stitch images.
- Storing/running one or more software modules for the purpose of stitching images, based on obtained shift (Δ) values; if necessary, calculating adjustments δ to an obtained shift value A, so as to cope with drift scenarios.
Such software may comprise an off-the-shelf product, such as *AutoStitch,* for example.

It should be noted that many refinements and alternatives of such a set-up will be known to the skilled artisan, including, but not limited to, the use of dual beams (for example an electron beam 404 for imaging and an ion beam for machining (or, in some cases, imaging the sample 410), and/or the use of a controlled environment at the sample 410 (for example, maintaining a pressure of several mbar - as used in a so-called Environmental SEM - or by admitting gasses, such as etching or precursor gasses), *etc.*

## Claims

1. A method of producing a composite image of a sample (410) using a charged-particle microscope (400), the composite image comprising a plurality of sub-images that are stitched together along overlap zones, said method comprising the following steps:
- Mounting the sample (410) on a sample holder (408);
- Using a particle-optical column (402) to direct at least one input beam (404) of particulate radiation onto the sample (410), thereby producing an interaction that causes a plurality of different types of output radiation to emanate from the sample (410);
- Detecting a first type of output radiation and using it to produce:
■ A sub-image I_{1A} of a primary region R_{A} of the sample;
■ A sub-image I_{1B} of a secondary region R_{B} of the sample,
whereby R_{B} is adjacent to R_{A} and overlaps partially therewith, and I_{1B} has an overlap zone Z₁ with I_{1A},
**characterized by** the following steps:
- Detecting a second type of output radiation, different to said first type, and using it to produce:
■ A sub-image I_{2A} of primary region R_{A};
■ A sub-image I_{2B} of secondary region R_{B},
whereby I_{2B} has an overlap zone Z₂ with I_{2A};
- Using computer processing apparatus (424) to:
■ Elect one of the sub-image pairs (I_{1A}, I_{1B}) and (I_{2A}, I_{2B});
■ For the sub-image pair thus elected, calculate the relative shift Δ of its two sub-images that is required to bring them into mutual registration, and stitch the two sub-images together after effecting this shift Δ;
■ For the other of the sub-image pairs, stitch its two sub-images together on the basis of the same relative shift Δ.

2. A method as claimed in claim 1, wherein said computer processing apparatus (424) is used to:
- Examine correlation of I_{1B} to I_{1A} within zone Z₁;
- Examine correlation of I_{2B} to I_{2A} within zone Z₂;
- Use the outcome of these examinations in performing said election.

3. A method as claimed in claim 2, wherein said computer processing apparatus (424) is used to:
- Produce a match score M₁ that expresses an observed degree of unambiguous correlation between I_{1B} and I_{1A};
- Produce a match score M₂ that expresses an observed degree of unambiguous correlation between I_{2B} and I_{2A};
- Determine a best one of the match scores M₁, M₂ and, on that basis, perform said election.

4. A method as claimed in any preceding claim, wherein the first and second types of output radiation are detected simultaneously.

5. A method as claimed in any preceding claim, wherein the charged-particle microscope (400) images the sample by performing relative scanning motion of the sample (410) with respect to the input beam (404).

6. A method as claimed in claim 5, wherein the charged-particle microscope (400) comprises a device selected from the group comprising Scanning Electron Microscopes, Scanning Transmission Electron Microscopes, Focused Ion Beam microscopes, and combinations of these.

7. A method as claimed in any preceding claim, wherein said first and second types of output radiation are different members of the group formed by backscatter electrons, secondary electrons, X-rays, optical radiation, and secondary ions.

8. A charged-particle microscope (400) constructed and arranged to perform a method as claimed in any of claims 1-7.
